# EUROPEAN PATENT APPLICATION

(11) **EP 4 739 041 A1**
(43) Date of publication of application: **06.05.2026**
(21) Application number: 24905370.3
(22) Date of filing: 16.04.2024
(51) Int. Cl.: H10F 77/20, H10F 10/14, H10F 77/30

(54) **BIFACIAL SOLAR CELL, BATTERY MODULE AND PHOTOVOLTAIC SYSTEM**

(30) Priority: 22.12.2023 CN 202311780305
(71) Applicant: Zhejiang Aiko Solar Energy Technology Co., Ltd., Yiwu, Jinhua Zhejiang 322000 (CN)
(72) Inventor: WANG, Yongqian, Jinhua, Zhejiang 322000 (CN); ZHANG, Jianjun, Jinhua, Zhejiang 322000 (CN); YANG, Xinqiang, Jinhua, Zhejiang 322000 (CN); CHEN, Gang, Jinhua, Zhejiang 322000 (CN)
(74) Representative: EP&C
(86) International application number: PCT/CN2024/087934
(87) International publication number: WO 2025/129865

(57) **Abstract**

The present application is applicable to the technical field of solar cells. Arranged are a double-sided solar cell (100), a cell assembly (200) and a photovoltaic system (1000). In the double-sided solar cell (100), a silicon substrate (10) has a first surface (11) and a second surface (12) opposite to each other. A first doped layer (20) is located on the first surface (11). The first doped layer (20) has at least one first electrode arrangement region (21). A plurality of first barrier layers (30) are located on the first electrode arrangement regions (21) and is arranged at intervals in a first predetermined direction, so that the first electrode arrangement region (21) includes a first blocked region (212) blocked by the first barrier layer (30) and a first non-blocked region (211) not blocked by the first barrier layer (30). A first passivation film layer (40) covering the first barrier layer (30) and the first doped layer (20). A first finger electrode (50) is arranged in the first electrode arrangement region (21) and located above the first doped layer (20) and the first barrier layer (30). The first finger electrode (50) is made of a burn-through paste. At the first blocked region (212), the first finger electrode (50) penetrates through the first passivation film layer (40) to be in contact with the first barrier layer (30) and to be not in contact with the first doped layer (20); and at the first non-blocked region (211), the first finger electrode (50) penetrates through the first passivation film layer (40) to be in contact with the first doped layer (20).

## Description

### PRIORITY INFORMATION

The present application claims the priority and benefit of patent application 202311780305.4, filed with the China National Intellectual Property Administration on 22 December 2023, which are incorporated in their entireties herein by reference.

### Technical Field

The present application relates to the technical field of solar cells, and in particular, to a double-sided solar cell, a cell assembly, and a photovoltaic system.

### Background

Solar cell power generation is a sustainable source of clean energy, which can convert sunlight into electrical energy using the photovoltaic effect of a semiconductor p-n junction. Currently, in a double-sided solar cell (for example, a Topcon solar cell), a doped layer is formed on the front side of the silicon sheet, and a doped layer of another polarity is formed on the back side, and at the same time, both the front side and the back side are arranged with a passivation film layer and a finger.

In the related art, the finger may be made of a non-burn-through paste or a burn-through paste, and when the non-burn-through paste is used, perforation needs to be performed on the passivation film layer, The process thereof is complicated and laser damage is easily generated, and in order to avoid this problem, a through-firing paste is usually used to manufacture the finger, In the process of printing the paste to form an electrode, the paste of the finger penetrates through the passivation film layer and directly contacts the doped layer below.

### Summary

The present application provides a double-sided solar cell, a cell string, a cell assembly and a photovoltaic system.

The present application is realized as follows: the double-sided solar cell of the embodiment of the present application includes:
a silicon substrate, having a first surface and a second surface opposite to each other;
a first doped layer located on the first surface, the first doped layer having a plurality of first electrode arrangement regions;
a plurality of first barrier layers located on the first electrode arrangement region, wherein the plurality of the first barrier layers are arranged at intervals in a first predetermined direction, so that the first electrode arrangement region includes a first blocked region blocked by the first barrier layer and a first non-blocked region not blocked by the first barrier layer;
a first passivation film layer covering the first barrier layer and the first doped layer;
a first finger electrode extending in the first predetermined direction, the first finger electrode being arranged in the first electrode arrangement region and located above the first doped layer and the first barrier layer, the first finger electrode being made of a burn-through paste;
wherein at the first blocked region, the first finger electrode penetrates through the first passivation film layer to be in contact with the first barrier layer and to be not in contact with the first doped layer; and at the first non-blocked region, the first finger electrode penetrates through the first passivation film layer to be in contact with the first doped layer.

The present application further provides a cell assembly. The cell assembly includes a plurality of described double-sided solar cells.

The present application further provides a photovoltaic system. The photovoltaic system includes the described cell assembly.

Additional aspects and advantages of some embodiments of the present application will be given in part in the following description, become apparent in part from the following description, or be learned from the practice of some embodiments of the present application.

### Brief Description of the Drawings

Fig. 1 is a schematic structural diagram of a photovoltaic system according to an embodiment of the present application;
Fig. 2 is a schematic diagram of a planar structure of a double-sided solar cell according to an embodiment of the present application;
Fig. 3 is a schematic cross-sectional diagram of a double-sided solar cell in Fig. 2 along the line III-III;
Fig. 4 is a schematic cross-sectional diagram of a double-sided solar cell in Fig. 2 along the line IV-IV;
Fig. 5 is another schematic cross-sectional diagram of a double-sided solar cell in Fig. 2 along the line III-III;
Fig. 6 is yet another schematic cross-sectional diagram of a double-sided solar cell in Fig. 2 along the line III-III;
Fig. 7 is another schematic cross-sectional diagram of a double-sided solar cell in Fig. 2 along the line IV-IV;
Fig. 8 is still another schematic cross-sectional diagram of a double-sided solar cell in Fig. 2 along the line III-III;
Fig. 9 is still another schematic cross-sectional diagram of a double-sided solar cell in Fig. 2 along the line III-III;
Fig. 10 is still another schematic cross-sectional diagram of a double-sided solar cell in Fig. 2 along the line IV-IV.

### Detailed Description of the Embodiments

To make the objectives, technical solutions, and advantages of the present application clearer, the present application is further described in details below in combination with the drawings and embodiments. Examples of the embodiments will be illustrated in the accompanying drawings, wherein throughout the description, same or similar reference numerals represent same or similar elements or elements with same or similar functions. It should be noted that the embodiments described below with reference to the accompanying drawings are illustrative, and are intended to illustrate the present application, and shall not be understood as limiting the present application. In addition, it should be understood that the embodiments described herein are only intended to explain the present application, but not to limit the present application.

In the description of the present application, it should be understood that, orientations or position relationships indicated by terms such as "upper", "lower", "left", "right", "transverse" and "longitudinal" and the like are orientations or position relationships based on accompanying drawings and are only for the convenience of illustration of the specification and simplicity of illustration, rather than explicitly or implicitly indicate that apparatuses or components referred to herein must have a certain direction or be configured or operated in a certain direction and therefore cannot be understood as limitations to the present application.

**In** addition, the terms "first" and "second" are only used for descriptive purposes, and cannot be understood as indicating or implying relative importance or implicitly indicating the number of indicated technical features. Thus, features defined by "first" and "second" may explicitly or implicitly include one or more of the features. In the description of the present application, "a plurality of" refers to two or more than two, unless specified otherwise.

**In** the present application, unless specified or limited otherwise, a first feature being "above" or "below" a second feature may include a direct contact between the first feature and the second feature, and may also include another feature contact between the first feature and the second feature rather than a direct contact. **In** addition, the first feature being "above", "over", and "on" the second feature includes the first feature being right above and obliquely above the second feature or only refers to the first feature being at a higher horizontal level than the second feature. The first feature being "below", "underneath", and "under" the second feature includes the first feature being right below and obliquely below the second feature or only refers to the first feature being at a lower horizontal level than the second feature.

The following disclosure provides many different embodiments or examples for implementing different structures of the present application. In order to simplify the disclosure of the present application, components and settings of specific examples are described below. Of course, they are merely examples and are not intended to limit the present application. Furthermore, the present application may repeat reference numerals and/or reference letters in different examples for the purpose of simplicity and clarity, and does not in itself indicate a relationship between the various embodiments and/or arrangements discussed. In addition, the present application provides examples of various specific processes and materials, but those skilled in the art will recognize the application of other processes and/or the use of other materials.

### Embodiment I

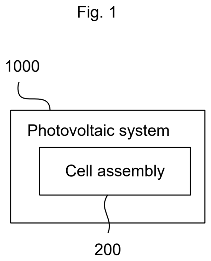

Please refer to Fig 1, the photovoltaic system 1000 in the embodiment of the present application may include the cell assembly 200 in the embodiment of the present application, and the cell assembly 200 in the embodiment of the present application may include a plurality of double-sided solar cells 100 in the embodiment of the present application.

Specifically, in the present application, the plurality of double-sided solar cells 100 in the cell assembly 200 may be connected together in series sequentially by means of a solder strip, so as to form cell strings. The cell strings in the cell assembly 200 may be connected in series or in parallel, or may be connected in series and in parallel, to achieve current convergence and output, for example, the connection between the cell strings can be achieved by bus bars.

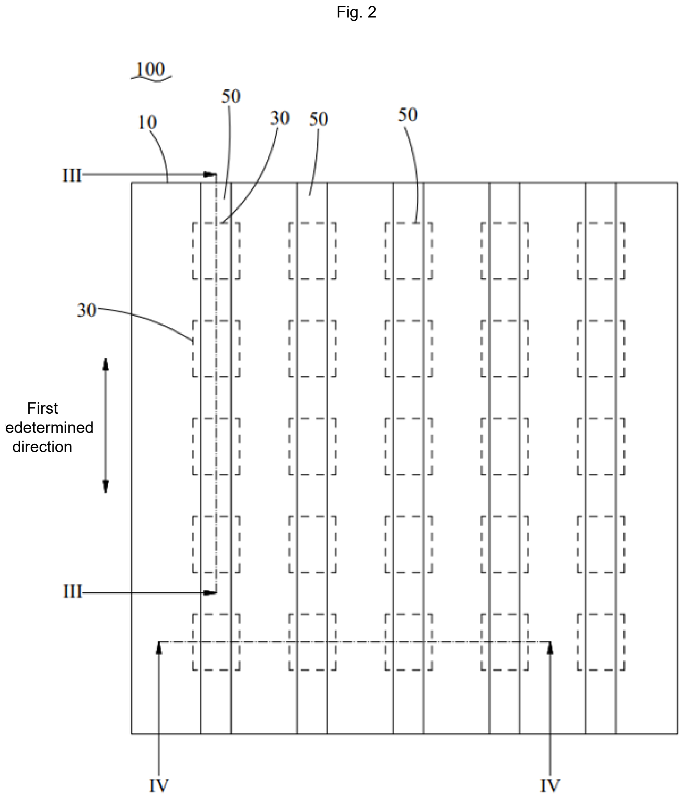

Please refer to Figs. 2 to 4, the double-sided solar cell 100 in the embodiment of the present application may include a silicon substrate 10, a first doped layer 20, a plurality of first barrier layers 30, a first passivation film layer 40 and a first finger electrode 50.

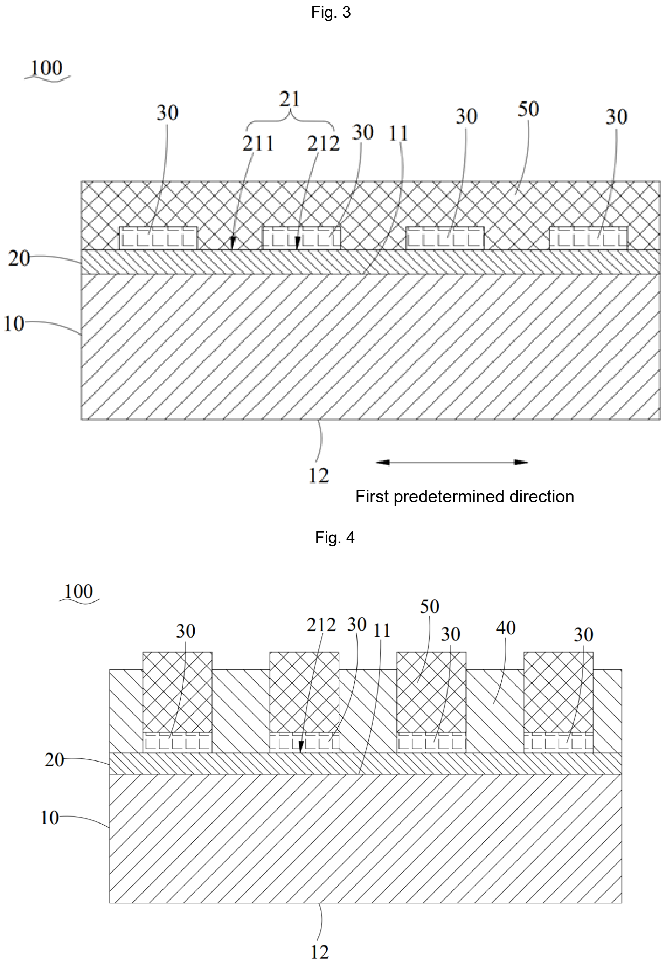

As shown in Fig. 3, the silicon substrate 10 has a first surface 11 and a second surface 12 opposite to each other, the two being the front surface and the back surface of the silicon substrate 10 respectively, which is not specifically limited herein. A first doped layer 20 is located on the first surface 11. The first doped layer 20 is arranged with a plurality of first electrode arrangement regions 21. The plurality of first barrier layers 30 are located on the first electrode arrangement regions 21 and are arranged at intervals in a first predetermined direction, so that the first electrode arrangement regions 21 include a first blocked region 212 blocked by a first barrier layer 30 and a first non-blocked region 211 not blocked by the first barrier layer 30.

The first passivation film layer 40 covers the first barrier layer 30 and the first doped layer 20; the first finger electrode 50 extends in a first predetermined direction; the first finger electrode 50 is arranged in the first electrode arrangement region 21 and is located above the first doped layer 20 and the first barrier layer 30; and the first finger electrode 50 is made of a burn-through paste.

As shown in Fig. 3, at the first blocked region 212, the first finger electrode 50 penetrates through the first passivation film layer 40 to be in contact with the first barrier layer 30 and to be not in contact with the first doped layer 20; at the first non-blocked region 211, the first finger electrode 50 penetrate through the first passivation film layer 40 to contact with the first doped layer 20 (it should be noted that, as Fig. 3 is a cross-sectional view along the extending direction of the first finger electrode 50, at this position, the first passivation film layer 40 is almost entirely ablated, the first passivation film layer 40 is not shown in Fig. 3).

**In** the related art, at the position of the finger, the burn-through paste generally burns through the passivation film layer completely to make full contact with the doped layer at the lower portion, i.e. the finger is in full contact with doped layer, without the ability to selectively burn through the passivation film layer, thus resulting in an excessively large contact area between the finger and the doped layer, leading to severe recombination in the metallization regions and, consequently reducing the conversion efficiency.

**In** the double-sided solar cell 100, the cell assembly 200 and the photovoltaic system 1000 in the embodiment of the present application, the plurality of first barrier layers 30 are arranged at intervals in the first predetermined direction in the first electrode arrangement region 21 of the first doped layer 20. The first finger electrode 50 is also arranged on the first electrode arrangement region 21 in first predetermined direction; at the first blocked region 212, the first finger electrode 50 penetrates through the first passivation film layer 40 to be in contact with the first barrier layer 30 and to be not in contact with the first doped layer 20; and at the first non-blocked region 211, the first finger electrode 50 penetrates through the first passivation film layer 40 to be in contact with the first doped layer 20.

In this way, in the process of manufacturing the first finger electrode 50 with the burn-through paste, the first finger electrode 50 can only burn through the first passivation film layer 40 at the first non-blocked region 211 to be in contact with the first doped layer 20, however, at the first blocked region 212, only the first passivation film layer 40 is burned through to be contact with the first barrier layer 30, without being in direct contact with the first doped layer 20, which allows the selective burn-through by the burn-through paste, reducing the metallization contact area between the first finger electrode (50) and the first doped layer (20) and decreasing recombination in the metallization regions, thereby enhancing the conversion efficiency of the double-sided solar cell (100).

Specifically, in the embodiment of the present application, the double-sided solar cell 100 may be a PERC solar cell, and may also be a Topcon solar cell, which is not specifically limited herein, and may preferably be a Topcon solar cell. When the double-sided solar cell is a Topcon solar cell, it may be a single-sided Topcon solar cell or a double-sided Topcon solar cell, which is not specifically limited herein.

In the present application, the first surface 11 and the second surface 12 may be the front surface and the back surface of the silicon substrate 10, respectively; the silicon substrate 10 may be a P-type silicon substrate or an N-type silicon substrate; the first doped layer 20 may be a P-type doped layer or an N-type doped layer; the first doped layer 20 may be formed on the first surface 11 of a silicon wafer by deposition, and in some embodiments, the first doped layer 20 may also be formed on the silicon substrate 10 by means of diffusion, which is not specifically limited herein, and in this case, the substrate portion below the first doped layer 20 formed by diffusion may be regarded as the silicon substrate 10.

It should be noted that, in the present application, the burn-through paste refers to a metal paste a relatively strong burn-through capability, which may be a silver paste, a silver-aluminum paste, or other pastes, and can completely burn through the first passivation film layer 40, so that the first finger electrode 50 can be in contact with the doped layer below the first passivation film layer 40. For example, in one possible embodiment, the glass powder content of the burn-through paste may be higher than that of a conventional paste, resulting in a stronger burn-through capability.

In the present application, the first electrode arrangement region 21 is a region, covered by the first finger electrode 50, on the first doped layer 20; the first predetermined direction is an extending direction of the first finger electrode 50; when the first finger electrode 50 is arranged along the transverse direction of the cell, the first predetermined direction is a transverse direction, and when the first finger electrode 50 is arranged along the longitudinal direction of the cell, the first predetermined direction is a longitudinal direction; and the arrangement direction of the first finger electrode 50 can be selected according to practical situations, and is not limited herein.

### Embodiment II

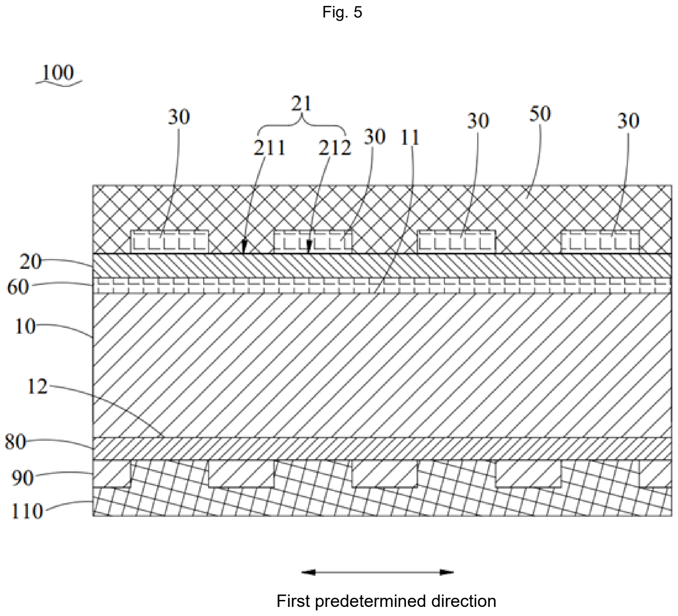

Please refer to Fig. 5, in some embodiments, the double-sided solar cell 100 can further include a second doped layer 80, a second passivation film layer 90 and a second finger electrode 110; the second finger electrode 110 is located on the second surface 12; the polarity of the second doped layer 80 is opposite to that of the first doped layer 20; the second doped layer 80 is arranged with a plurality of second electrode arrangement regions 81; and the second passivation film layer 90 is arranged on the second doped layer 80. The second finger electrode 110 is arranged in the second electrode arrangement region 81 and is located above the second passivation film layer 90; and the second finger electrode 110 at least partiallyburns through the second passivation layer 90 to be in contact with the second doped layer 80.

Specifically, in such an embodiment, the double-sided solar cell 100 is a Topcon solar cell; one of the first doped layer 20 and the second doped layer 80 is a P-type doped layer, and the other is an N-type doped layer; and one of the first finger electrode 50 and the second finger electrode 110 is a P-type electrode, and the other is an N-type electrode.

Further, in some embodiments, the first barrier layer 30 may be a third doped layer having a polarity opposite to that of the first doped layer 20 and the same as that of the second doped layer 80.

In some embodiments, the first doped layer 20 can be formed on the first surface 11 by means of diffusion or deposition; the second doped layer 80 can also be formed on the second surface 12 by means of diffusion or deposition; and in the process of forming the second doped layer 80, the first barrier layer 30 can be formed by locally removing a portion of an wrap plating layer formed on the first doped layer 20.

In the following, two formation modes of the second doped layer 80 will be described in details:
The first case: the second doped layer 80 is formed by means of deposition; in this case, after the first doped layer 20 is formed on the first surface 11, in the process of depositing the second doped layer 80, an wrap plating layer with a doping property is formed on the first doped layer 20; in the conventional technical solution, during the subsequent process, the wrap plating layer needs to be removed completely, while in the present application, the wrap plating layer may only be removed locally, retaining the wrap plating layer at the first blocked region 212, thus, the first barrier layer 30 in the present application is formed; and in this case, the first barrier layer 30 includes a third doped layer with the same polarity as the second doped layer 80. It can be understood that, when the first doped layer 20 is a P-type doped layer and the second doped layer 80 is an N-type doped layer, the first barrier layer 30 is an N-type doped layer; and when the first doped layer 20 is an N-type doped layer and the second doped layer 80 is a P-type doped layer, the first barrier layer 30 is a P-type doped layer.

The second case: the second doped layer 80 is formed on the second surface 12 by means of diffusion; in this case, when the first doped layer 20 is a P-type doped layer and the second doped layer 80 is an N-type doped layer, the second doped layer 80 may be formed on the second surface 12 by diffusion of phosphorus.

In the process of forming the first doped layer 20, a borosilicate glass film layer is formed on the surface of the first doped layer 20; when the second doped layer 80 is formed by diffusion, if the borosilicate glass film on the first doped layer 20 is not removed, then a borophosphosilicate glass film layer or a combination layer of the borosilicate glass film layer and the borophosphosilicate glass film layer is formed on the first doped layer 20; in such a case, the first barrier layer 30 can be formed on the first blocked region 212 only by removing the borophosphosilicate glass film layer or the combination layer of the borosilicate glass film layer and the borophosphosilicate glass film layer at the partial region of the first doped layer 20, that is, the first barrier layer 30 is a borophosphosilicate glass film layer or a combination layer of the borosilicate glass film layer and the borophosphosilicate glass film layer.

If the borosilicate glass film layer on the first doped layer 20 is removed before the second doped layer 80 is formed by diffusion, a phosphorosilicate glass film layer may be formed on the first doped layer 20. In this case, the first barrier layer 30 may be formed on the first blocking region 212 only by removing the phosphorosilicate glass film layer at a local region on the first doped layer 20, that is, the first barrier layer 30 is a phosphorosilicate glass film layer.

By the same reasoning, when the first doped layer 20 is an N-type doped layer and the second doped layer 80 is a P-type doped layer, the second doped layer 80 can be formed on the second surface 12 by means of diffusion of boron.

In the process of forming the first doped layer 20, a phosphorosilicate glass film layer is formed on the surface of the first doped layer 20; when the second doped layer 80 is formed by diffusion, if the phosphorosilicate glass film on the first doped layer 20 is not removed, then a borophosphosilicate glass film layer or a combination layer of the phosphorosilicate glass film layer and the borophosphosilicate glass film layer is formed on the first doped layer 20; in such a case, the first barrier layer 30 can be formed on the first blocked region 212 only by removing the borophosphosilicate glass film layer or the combination layer of the phosphorosilicate glass film layer and the borophosphosilicate glass film layer at the partial region of the first doped layer 20, that is, the first barrier layer 30 is a borophosphosilicate glass film layer or a combination layer of the borosilicate glass film layer and the borophosphosilicate glass film layer.

If the phosphorosilicate glass film layer on the first doped layer 20 is removed before the second doped layer 80 is formed by diffusion, a borosilicate glass film layer may be formed on the first doped layer 20. In this case, the first barrier layer 30 may be formed on the first blocking region 212 only by removing the borosilicate glass film layer at a local region on the first doped layer 20, that is, the first barrier layer 30 is a borosilicate glass film layer.

### Embodiment IV

In some embodiments, the double-sided solar cell 100 may also be a PERC solar cell; the first doped layer 20 may be formed on the silicon substrate 10 by means of diffusion or deposition; in such case, the first barrier layer 30 may be a phosphorosilicate glass film layer or a borosilicate glass film layer, for example, when the first doped layer 20 is formed by means of diffusion of boron, the first barrier layer 30 may be a borosilicate glass film, and when the first doped layer 20 is formed by means if diffusion of phosphorus, the first barrier layer 30 may be a phosphorosilicate glass film layer.

It is not difficult to understand that, in general, in the process of forming the first doped layer 20 by means of diffusion, a borosilicate glass film layer or a phosphosilicate glass film layer is formed on the first doped layer 20; and after the diffusion is completed, the borosilicate glass film layer or the phosphosilicate glass film layer is usually removed. In the present application, the first barrier layer 30 may be formed by retaining the borosilicate glass film layer or the phosphorosilicate glass film layer at the first blocked region 212 in the process of removing the borosilicate glass film layer or the phosphorosilicate glass film layer.

It can be determined from the above that, in the present application, on the basis of the type of the double-sided solar cell 100 and different forming processes based on the second doped layer 80, the first barrier layer 30 can be different film layers, that is, in the present application, the first barrier layer 30 can include at least one of a borosilicate glass film layer, a phosphosilicate glass film layer, a borophosphosilicate glass film layer and a third doped layer having a polarity opposite to that of the first doped layer 20 and the same as that of the second doped layer 80.

### Embodiment V

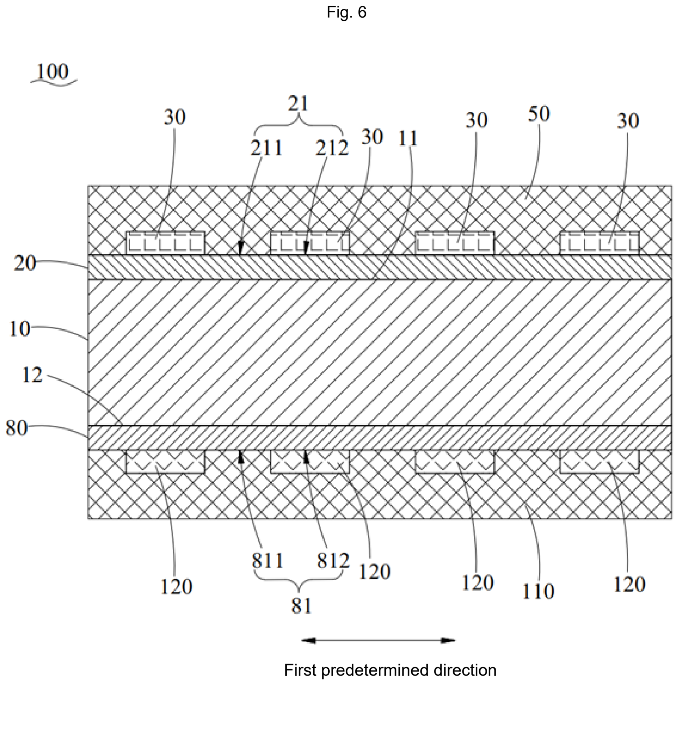

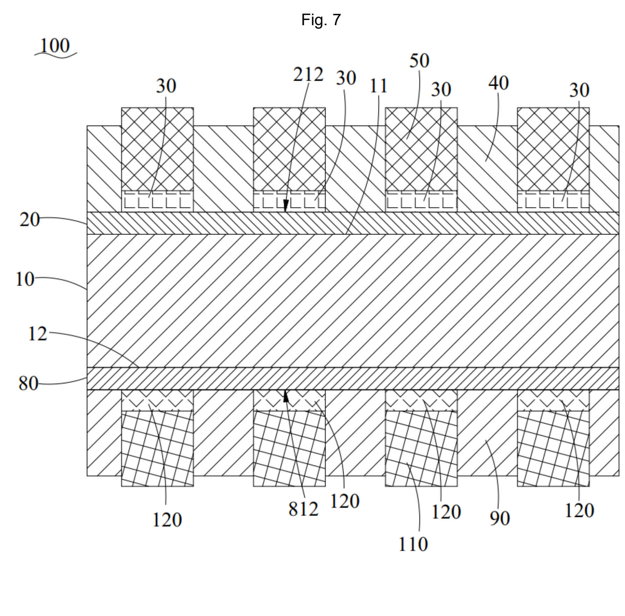

Please refer to Figs. 6 and 7, in some embodiments, the double-sided solar cell 100 can further include a plurality of second barrier layers 120 located on the second electrode arrangement region 81; the plurality of second barrier layers 120 are stacked on the second doped layer 80 and are spaced apart in the second predetermined direction, so that the second electrode arrangement region 81 includes a second blocked region 812 blocked by the second barrier layer 120 and a second unobstructed region 811 not blocked by the second barrier layer 120; in the present embodiment, the second predetermined direction may be the same as the first predetermined direction.

The second finger electrode 110 also extends in the second predetermined direction and is located above the second doped layer 80 and the second barrier layer 120; at the second blocked region 812, the second finger electrode 110 penetrates through the second passivation film layer 90 to be in contact with the second barrier layer 120 and to be not in contact with the second doped layer 80; and at the second unobstructed region 811, the second finger electrode 110 penetrates through the second passivation film layer 90 to be in contact with the second doped layer 80.

**In** this way, by means of the arrangement of the second barrier layer 120, in the process of manufacturing the second finger electrode 110, the second finger electrode 110 can only burn through the second passivation film layer 90 at the second unobstructed region 811 to be in contact with the second doped layer 80, however, at the second light blocked region 812, only the second passivation film layer 90 is burned through to be contact with the second barrier layer 120, without being in direct contact with the second doped layer 80, which allows the selective burn-through by the burn-through paste, reducing the metallization contact area between the second finger electrode 110 and the second doped layer 80 and decreasing recombination in the metallization regions, thereby enhancing the conversion efficiency of the double-sided solar cell 100. In such an embodiment, the double-sided solar cell 100 may be a double-sided Topcon solar cell, which is not specifically limited herein.

Specifically, in such an embodiment, the second doped layer 80 may be formed by means of deposition or diffusion; when the second doped layer 80 is an N-type doped layer, a phosphorosilicate glass film layer is formed on the second doped layer 80 in the process of forming the second doped layer 80, in the subsequent removal process, the phosphorosilicate glass film layer at the second blocked region 812 of the second doped layer 80 is retained to form the second barrier layer 120, that is, the second barrier layer 120 is a phosphorosilicate glass film layer.

When the second doped layer 80 is a P-type doped layer, a borosilicate glass film layer is formed on the second doped layer 80 in the process of forming the second doped layer 80; and in the subsequent removal process, the borosilicate glass film layer at the second blocked region 812 of the second doped layer 80 is retained to form the second barrier layer 120, that is, the second barrier layer 120 is a borosilicate glass film layer.

### Embodiment VI

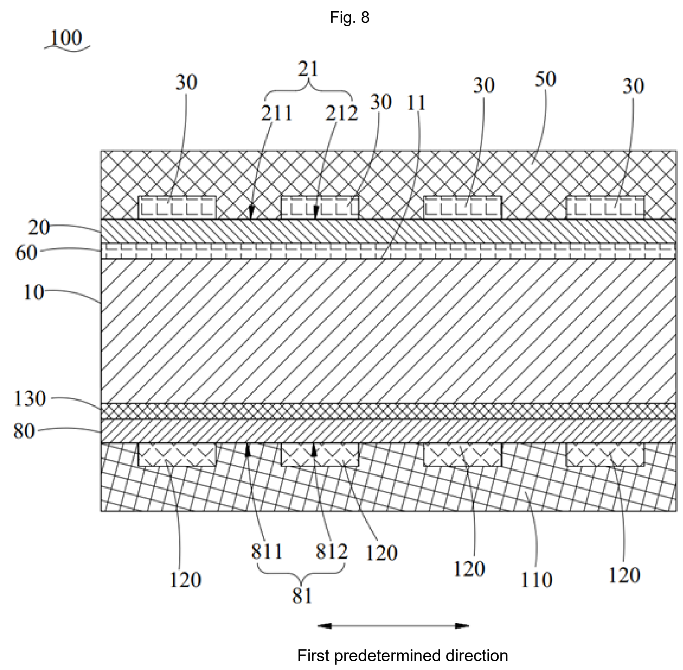

Please refer to Fig. 8, in some embodiments, a first tunneling layer 60 is arranged between the first doped layer 20 and the first surface 11.

In this way, the first tunneling layer 60 can be arranged to achieve the tunneling passivation function for the first surface 11, thereby enhancing the passivation effect of the first surface 11.

In some embodiments, a second tunneling layer 130 may be arranged between the second doped layer 80 and the second surface 12. In this way, the second tunneling layer 130 can be arranged to achieve the tunneling passivation function for the second surface 12, thereby enhancing passivation effect on the second surface 12.

Specifically, in such an embodiment, when the double-sided solar cell 100 is only arranged with the first tunneling layer 60, the double-sided solar cell 100 is a single-sided Topcon solar cell; and when the double-sided solar cell 100 is arranged with both the first tunneling layer 60 and the second tunneling layer 130, the double-sided solar cell 100 is a double-sided Topcon solar cell, which is not specifically limited herein. The first tunneling layer 60 and the second tunneling layer 130 may both be tunneling silicon oxide film layers.

### Embodiment VII

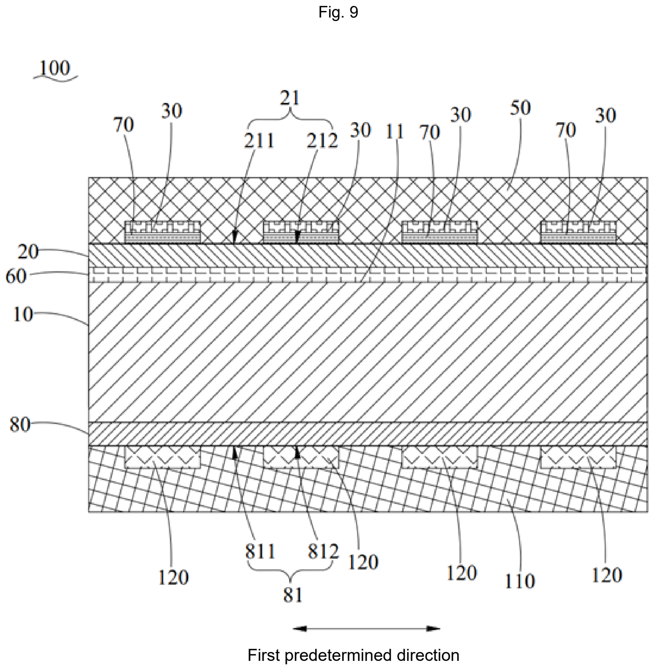

Please refer to Fig. 9, in some embodiments, a dielectric layer 70 is arranged between the first doped layer 20 and the first barrier layer 30; the first barrier layer 30 is stacked on the dielectric layer 70 and located between the dielectric layer 70 and the first passivation film layer 40; and the first barrier layer 30 is insulated from the first doped layer 20 by the dielectric layer 70.

In this way, the arrangement of the dielectric layer 70 can insulate the first barrier layer 30 from the first doped layer 20, and can avoid current leakage when the first barrier layer 30 is a doped layer (i.e. the third doped layer mentioned above) with a polarity opposite to that of the first doped layer 20.

Further, in such an embodiment, the dielectric layer 70 may include at least one or a combination of a plurality of a borosilicate glass film layer, a phosphosilicate glass film layer and a borophosphosilicate glass film layer.

In particular, in such an embodiment, the double-sided solar cell 100 may be the Topcon solar cell having the second doped layer 80; the first barrier layer 30 is the third doped layer having the same polarity as the second doped layer 80 in the described embodiment; and on the basis of different processes for forming the second doped layer 80, the dielectric layer 70 is at least one of the borosilicate glass film layer, the phosphorosilicate glass film layer or the borophosphosilicate glass film layer.

For example, when the first doped layer 20 is a P-type doped layer and the second doped layer 80 is an N-type doped layer, when the first doped layer 20 is formed, a borosilicate glass film layer is formed above the first doped layer 20; when the borosilicate glass film layer is not removed and the second doped layer 80 is formed by means of deposition, a borosilicate glass film layer, a borophosphosilicate glass film layer (both being dielectric layers 70) and a first barrier layer 30 (i.e. the N-type doped layer) are sequentially arranged above the first doped layer 20; and when the borosilicate glass film layer on the first doped layer 20 is removed, a phosphorosilicate glass film layer (i.e. the dielectric layer 70) and a first barrier layer 30 (i.e. the N-type doped layer) are arranged above the first doped layer 20. In addition, when the second doped layer 80 is formed by means of diffusion, a borosilicate glass film layer (i.e. the dielectric layer 70) and a borophosphosilicate glass film layer (i.e. the first barrier 30) are sequentially formed on the first doped layer 20.

When the first doped layer 20 is an N-type doped layer and the second doped layer 80 is a P-type doped layer, and when the first doped layer 20 is formed, a phosphorosilicate glass film layer is formed above the first doped layer 20; and when the phosphorosilicate glass film layer is not removed and the second doped layer 80 is formed by means of deposition, a phosphorosilicate glass film layer, a borophosphosilicate glass film layer (both being dielectric layers 70) and a first barrier layer 30 (i.e. the P-type doped layer) will be sequentially arranged above the first doped layer 20. In addition, when the second doped layer 80 is formed by means of diffusion, a borosilicate glass film layer (i.e. the dielectric layer 70) and a phosphorosilicate glass film layer (i.e. the first barrier 30) are sequentially formed on the first doped layer 20.

### Embodiment VIII

In some embodiments, the first doped layer 20 is a P-type doped layer, and both the first barrier layer 30 and the second doped layer 80 are N-type doped layers.

Thus, the first barrier layer 30 on the P-type doped layer is an N-type doped layer; and by arranging the N-type doped layer on the P-type doped layer, the bonding tension between the passivation film layer and the N-type doped layer is greater than the bonding tension between the passivation film layer and the P-type doped layer, when solder pads are subsequently arranged, a soldering strength of the solder pads during soldering can be effectively improved, thereby effectively preventing the solder pads from falling off during soldering, improving the reliability of soldering.

Specifically, in such an embodiment, the double-sided solar cell 100 is a Topcon solar cell, the first doped layer 20 is a P-type doped layer, the second doped layer 80 is an N-type doped layer, and the first barrier layer 30 is an N-type doped layer obtained by locally removing the overplating formed on the first doped layer 20 when the N-type doped layer is formed.

### Embodiment IX

**In** some embodiments, the bonding tension between the first finger electrode 50 and the first barrier layer 30 is greater than the bonding tension between the first finger electrode 50 and the first doped layer 20.

In this way, the stability of the first finger electrode 50 can be improved by providing the first barrier layer 30, and the first finger electrode 50 can be effectively prevented from deviating and falling off.

### Embodiment X

In some embodiments, the bonding tension between the first barrier layer 30 and the first passivation film layer 40 is greater than the bonding tension between the first doped layer 20 and the first passivation film layer 40.

In this way, the bonding tension of the first barrier layer 30 and the first passivation film layer 40 is large, which can effectively increase the soldering strength of the solder pads arranged on the first passivation film layer 40, and prevent the solder pads from falling off during soldering.

Specifically, in such an embodiment, the first doped layer 20 is a P-type doped layer, the first barrier layer 30 is an N-type barrier layer, and the bonding tension between the N-type doped layer and the first passivation film layer 40 is greater than the bonding tension between the P-type doped layer and the first passivation film layer 40.

Further, in such an embodiment, in some embodiments, the double-sided solar cell 100 further includes a plurality of solder pads (not shown) connected to the first finger electrode 50, and each of the solder pad is arranged on the first passivation film layer 40 and at least partially located above the first barrier layer 30.

In this way, at least partially arranging the each of the solder pad above the first barrier layer 30 can increase the soldering strength of the solder pad during soldering.

Furthermore, in some embodiments, at least one of the solder pad burns through the first passivation film layer 40 to be in contact the first barrier layer 30, and the bonding tension between the each of the solder pad and the first barrier layer 30 is greater than the bonding tension between the each of the solder pad and the first doped layer 20.

In this way, the bonding tension between the each of the solder pad and the first barrier layer 30 is large, which can also effectively improve the soldering strength of the each of the solder pad during soldering.

Specifically, in such an embodiment, the each of the solder pad may be a P-type solder pad, and the paste for forming the each of the solder pad may be the same as or different from the paste for forming the first finger electrode 50, which is not specifically limited herein.

### Embodiment XI

In some embodiments, a projected area of each of the first barrier layer 30 on the silicon substrate 10 is greater than or equal to a projected area of the each of the solder pad on the silicon substrate 10, and the solder pad is completely located within the projected area of the first barrier layer 30.

In this way, the solder pad is completely located in the region where the first barrier layer 30 is located, with the entire region below the solder pad covered by the first barrier layer 30, which maximizes the soldering strength at the solder pad, thereby ensuring the reliability of the soldering process.

Specifically, in such an embodiment, the area of the each of the first barrier layer 30 may preferably be just equal to the projected area of the each of the solder pad or slightly greater than the projected area of the each of the solder pad, which is not specifically limited herein.

### Embodiment XII

Please refer to Fig. 1, in some embodiments, in the first predetermined direction, a ratio of a length of the first finger electrode 50 being in contact with the first doped layer 20 to a total length of the first finger electrode 50 is 30-80%.

In this way, the length of the first finger electrode 50 being in contact with the first doped layer 20 is set to be within the range of the ratio, so that the metallization contact area can be effectively reduced, so as to reduce the recombination and avoid an excessive resistance caused by the over-small contact area, that is, the relationship between the recombination and the resistance can be balanced to improve the efficiency of the double-sided solar cell 100.

In particular, in such an embodiment, the ratio of a length of the first finger electrode 50 being in contact with the first doped layer 20 to the total length of the first finger electrode 50 may be, for example, 30%, 40%, 50%, 60%, 70%, 80% or any one of 30%-80%.

Further, in such an embodiment, after careful research and further exploration by the inventors of the present application, it has been discovered that in order to improve the conversion efficiency of the double-sided solar cell 100 as much as possible while balancing the metallization composition and the resistance to the maximum, the ratio of a length of the first finger electrode 50 being in contact with the first doped layer 20 to the total length of the first finger electrode 50 may preferably be with the range of 40-60%, for example, 40%, 45%, 50%, 55%, 60%, or any one of 40-60%.

### Embodiment XIII

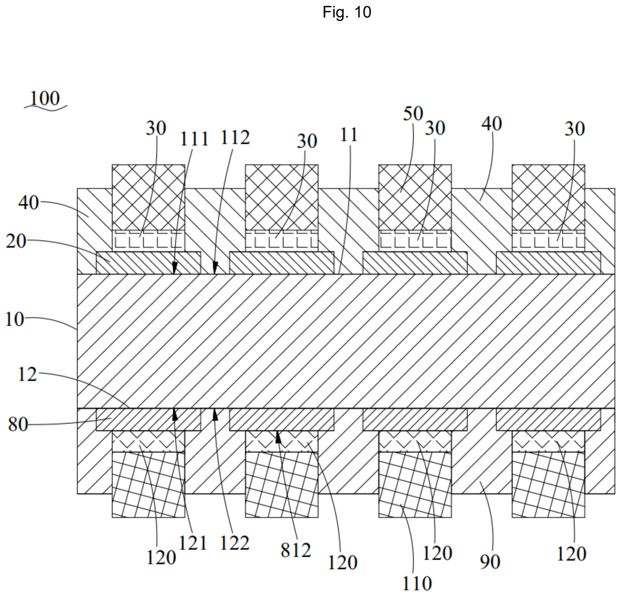

Please refer to Fig. 10, in some embodiments, the first surface 11 is arranged a plurality of first regions 111 and second regions 112 which are arranged alternately in sequence; the first doped layer 20 is arranged on the first region 111 and does not cover the second region 112, and a plurality of first barrier layers 30 are arranged above the first doped layer 20 on at least one of the first regions 111.

In this way, the first doped layer 20 only covers the first region 111 of the first surface 11 and does not cover the second region 112, and the first surface 11 of the silicon substrate 10 is not completely covered by the first doped layer 20, thereby effectively reducing the parasitic absorption of light by the first doped layer 20, and improving the conversion efficiency.

Further, in some embodiments, the silicon substrate 10 may preferably be a P-type silicon substrate 10, the first surface 11 is a front surface, the second surface 12 is a back side, the first doped layer 20 is a P-type doped layer, and the second doped layer 80 is an N-type doped layer.

Thus, on the one hand, a P-type silicon substrate 10 is used, as the preparation technology of the P-type silicon substrate 10 is more mature than that of an N-type substrate; on the other hand, the p-type doped layer only covering the first region 111 is used on the front side of the P-type silicon substrate 10, as the P-type doped layer has a poor passivation effect on the P-type silicon substrate 10, the P-type doped layer is only arranged on the first region 111 to perform local passivation, the second region 112 is directly passivated using the first passivation film layer 40, the passivation performance is good, and the passivation effect of the first surface 11 can be improved, thereby improving the electrical performance of the solar cell, and further improving the efficiency.

In some embodiments, the thickness of the second doped layer 80 is less than the thickness of the first doped layer 20.

In this way, when the silicon substrate 10 is a P-type silicon substrate 10 and the first doped layer 20 is a P-type doped layer, arranging the first doped layer 20 to be relatively thick can improve the passivation effect of the first surface 11, thereby improving the electrical performance of the cell.

In some embodiments, the first doped layer 20 and the second doped layer 80 may each include a doped semi-insulating polysilicon layer. In this way, the materials of the first doped layer 20 and the second doped layer 80 are both semi-insulating polycrystalline silicon, which has less parasitic absorption compared with conventional polycrystalline silicon, that is, such materials can be used to reduce parasitic absorption and improve conversion efficiency.

### Embodiment XIIII

In some embodiments, the ratio of the area of the first region 111 to the area of the first surface 11 (i.e., the area proportion of the first region 111) is less than 8%.

In this way, setting the ratio of the area of the first region 111 to the area of the first surface 11 to be less than 8% can greatly reduce the area proportion of the first doped layer 20, thereby reducing the parasitic absorption of the first doped layer 20 and improving the efficiency.

Furthermore, when the silicon substrate 10 is a P-type silicon substrate 10, the first doped layer 20 is a P-type doped layer, and the first surface 11 is the front side, the area of the first region 111 is set to be small, so that the area of the second region 112 can be increased, thereby improving the passivation effect of the first surface 11, i.e., improving the passivation effect of the first surface 11 while reducing the parasitic absorption, thereby improving the efficiency.

Further, in such an embodiment, the ratio of the area of the first region 111 to the area of the first surface 11 is preferably less than 6%, and most preferably less than 5%.

### Embodiment XV

Please refer to Fig. 10, in some embodiments, the second surface 12 may have a plurality of third regions 121 and fourth regions 122 which are arranged alternately in sequence, and the second doped layer 80 is arranged on the third regions 121 and does not cover the fourth regions 122.

In this way, the second doped layer 80 covers only the third region 121 of the second surface 12 and does not cover the fourth region 122. In this way, the second surface 12 of the silicon substrate 10 is not completely covered by the second doped layer 80, which can effectively reduce the parasitic absorption of light by the second doped layer 80, and improve the conversion efficiency.

In some embodiments, the ratio of the area of the third region 121 to the area of the second surface 12 is greater than or equal to 30% and less than 100%.

**In** this way, when the silicon substrate 10 is a P-type silicon substrate 10, the second doped layer 80 is an N-type doped layer, and the second surface 12 is a back side, the area of the third region 121 of the second surface 12 is set to be large, which can also ensure the area proportion of the N-type doped layer and balance the passivation contact area and the parasitic absorption while reducing the parasitic absorption, thereby improving the conversion efficiency.

Further, in such an embodiment, the ratio of the area of the third region 121 to the area of the second surface 12 is preferably greater than or equal to 40% and less than 100%, and still further, in such an embodiment, the ratio of the area of the third region 121 to the area of the second surface 12 is more preferably greater than or equal to 50% and less than 100%, and most preferably greater than or equal to 60% and less than 100%.

**In** the illustration of the description, the illustration of reference terms "an embodiment", "some embodiments", "an example", "a specific example", or "some examples" means that specific features, structures, materials, or characteristics described in connection with the embodiment or example is included in at least one embodiment or example the present application. In the description, the illustrative expressions of the described terms do not necessarily refer to the same embodiment or example. Furthermore, the specific features, structures, materials, or characteristics described may be combined in any suitable manner in one or more embodiments or examples.

**In** addition, the described content merely relates to preferred embodiments of the present application, and is not intended to limit the present application, and any modifications, equivalent replacements, improvements, etc. made within the spirit and principle of the present application shall all fall within the scope of protection of the present application.

## Claims

1. A double-sided solar cell, comprising:
a silicon substrate, having a first surface and a second surface opposite to each other;
a first doped layer located on the first surface, the first doped layer has a plurality of first electrode arrangement regions;
a plurality of first barrier layers located on the first electrode arrangement region, wherein the plurality of the first barrier layers are arranged at intervals in a first predetermined direction, so that the first electrode arrangement region comprises a first blocked region blocked by the first barrier layer and a first non-blocked region not blocked by the first barrier layer;
a first passivation film layer covering the first barrier layer and the first doped layer;
a plurality of first finger electrodes extending in the first predetermined direction, the first finger electrode being arranged in the first electrode arrangement region and located above the first doped layer and the first barrier layer, the first finger electrode being made of a burn-through paste;
wherein at the first blocked region, the first finger electrode penetrates through the first passivation film layer to be in contact with the first barrier layer and to be not in contact with the first doped layer; and at the first non-blocked region, the first finger electrode penetrates through the first passivation film layer to be in contact with the first doped layer.

2. The double-sided solar cell according to claim 1, wherein a first tunneling layer is arranged between the first doped layer and the first surface.

3. The double-sided solar cell according to claim 1, wherein a dielectric layer is located between the first doped layer and the first barrier layer; the first barrier layer is stacked on the dielectric layer and located between the dielectric layer and the first passivation film layer; and the first barrier layer is insulated from the first doped layer by the dielectric layer.

4. The double-sided solar cell according to claim 3, wherein the dielectric layer comprises at least one or more combinations of a borosilicate glass film layer, a phosphosilicate glass film layer and a borophosphosilicate glass film layer.

5. The double-sided solar cell according to claim 1, wherein the first barrier layer comprises at least one of a borosilicate glass film layer, a phosphosilicate glass film layer, a borophosphosilicate glass film layer and a third doped layer, and a polarity of the third doped layer is opposite to that of the first doped layer.

6. The double-sided solar cell according to claim 1, wherein the first doped layer is a P-type doped layer, and the first barrier layer is an N-type doped layer.

7. The double-sided solar cell according to claim 1, wherein a bonding tension between the first finger electrode and the first barrier layer is greater than a bonding tension between the first finger electrode and the first doped layer.

8. The double-sided solar cell according to claim 1, wherein a bonding tension between the first barrier layer and the first passivation film layer is greater than a bonding tension between the first doped layer and the first passivation film layer.

9. The double-sided solar cell according to claim 8, further comprising a plurality of solder pads connected to the first finger electrode, wherein each of the solder pad is arranged on the first passivation film layer and at least partially located above the first barrier layer.

10. The double-sided solar cell according to claim 9, wherein at least one of the solder pad penetrates through the first passivation film layer to contact the first barrier layer, and a bonding tension between the each of the solder pad and the first barrier layer is greater than a bonding tension between the each of the solder pad and the first doped layer.

11. The double-sided solar cell according to claim 9, wherein a projected area of each of the first barrier layer on the silicon substrate is greater than or equal to a projected area of the each of the solder pad on the silicon substrate, and the each of the solder pad is completely located within a projection region of the first barrier layer.

12. The double-sided solar cell according to claim 1, wherein in the first predetermined direction, a ratio of a length of the first finger electrode being in contact with the first doped layer to a total length of the first finger electrode is 30-80%.

13. The double-sided solar cell according to claim 12, wherein in the first predetermined direction, the ratio between the length of the first finger electrode being in contact with the first doped layer to the total length of the first finger electrode is 40-60%.

14. The double-sided solar cell according to claim 1, wherein the first surface has a plurality of first regions and a plurality of second regions which are sequentially and alternately arranged; the first doped layer is arranged on the first region and do not cover the second region; and the plurality of the first barrier layers are arranged above the first doped layer on at least one the first region.

15. The double-sided solar cell according to claim 14, wherein a ratio of an area of the first region to an area of the first surface is less than 8%.

16. The double-sided solar cell according to any one of claims 1 to 15, wherein the double-sided solar cell further comprises:
a second doped layer arranged on the second surface, the polarity of the second doped layer being opposite to the polarity to the first doped layer, and the second doped layer has a plurality of second electrode arrangement regions;
a second passivation film layer arranged on the second doped layer; and
a plurality of second finger electrodes arranged in the second electrode arrangement region and located on the second doped layer, the second finger electrode at least partially burns through the second passivation layer to be in contact with the second doped layer.

17. The double-sided solar cell according to claim 16, wherein the double-sided solar cell further comprises a plurality of second barrier layers located on the second electrode arrangement region, and the plurality of the second barrier layers is stacked on the second doped layer and is arranged at intervals in a second predetermined direction, so that the second electrode arrangement region comprises a second blocked region blocked by the second barrier layer and a second non-blocked region not blocked by the second barrier layer;
wherein the second finger electrode extends in the second predetermined direction and is located above the second doped layer and the second barrier layer; at the second blocked region, the second finger electrode penetrates through the second passivation film layer to be in contact with the second barrier layer and to be not in contact with the second doped layer; and at the second non-blocked region, the second finger electrode penetrates through the second passivation film layer to be in contact with the second doped layer.

18. The double-sided solar cell according to claim 17, wherein the second doped layer is a borosilicate glass film layer or a phosphorosilicate glass film layer.

19. The double-sided solar cell according to claim 17, wherein a second tunneling layer is arranged between the second doped layer and the second surface.

20. The double-sided solar cell according to claim 16, wherein the second surface is arranged a plurality of third regions and a plurality of fourth regions which are sequentially and alternately arranged, and the second doped layer is arranged on the third region and do not cover the fourth region.

21. The double-sided solar cell according to claim 20, wherein a ratio of an area of the third region to an area of the second surface is greater than or equal to 30% and less than 100%.

22. A cell assembly, comprising a plurality of double-sided solar cells according to any one of claims 1 to 21.

23. A photovoltaic system comprising the cell assembly according to claim 22.
